# EUROPEAN PATENT APPLICATION

(11) **EP 1 777 919 A1**
(43) Date of publication of application: **25.04.2007**
(21) Application number: 05022685.1
(22) Date of filing: 18.10.2005
(51) Int. Cl.: H04M 1/02, H05K 7/20

(54) **A cooling system for a portable battery-operatable electronic device and a portable battery-operatable electronic device**

(71) Applicant: BenQ Corporation, Gueishan Taoyuan 333 (TW)
(72) Inventor: Gentsch, Morten Brok, 9000 Aalborg (DK); Mortensen, Lind, 9260 Gistrup (DK)
(74) Representative: Epping - Hermann - Fischer

(57) **Abstract**

A cooling system for a portable battery-operatable electronic device (2) having a housing (), comprises a heat conducting element (4) comprising at least three directional branches pointing in different directions, the heat conducting element (4) thermally coupled to a component (1), the component (1) preferably assembled on a circuit board (3), at least three of the directional branches each connected to at least one passage (5) leading to at least one opening in the exterior of the electronic device (2), or to a part of the exterior that is a water-proof structure, especially foil or coating, that is permeable for air, at least two of said openings or parts being on opposite sides of said housing.

A portable battery-operatable electronic device (2) comprises a component (1) mounted on a circuit board (3) and a cooling system.

## Description

### Field of the invention

The invention relates to cooling systems for portable battery-operatable electronic devices, and to portable battery-operatable electronic devices comprising a cooling system.

### Background

Designing a portable battery-operatable electronic device can be a very challenging task should the device comprise at least one component that can produce a lot of heat in use. One of the challenges is to ensure that excess heat will be efficiently removed from the portable battery-operatable electronic device in order not to compromise its operation.

Due to miniaturization of electronic devices and developments in microelectronics, portable battery-operatable electronic devices are to an increasing extent of a smaller size but comprise electronic components that run high in frequency and can generate much heat. State of the art cooling systems, such as fans, Peltier elements or passive heat sinks used to cool parts in electronic devices may not always provide an acceptable solution for devices of this kind. Fans and Peltier elements are sometimes unacceptable because of their relatively high energy consumption, passive heat sinks because of space constraints.

In order for the user not to burn him- or herself, the housing of the portable battery-operatable electronic device may need to be of plastic or of other material that does not conduct heat well. Also for this reason, the temperature of the outer surface of the housing usually must not exceed a certain temperature in order to fulfill the requirements of some security norms.

### Summary of the invention

The first objective of the invention is to improve cooling systems for portable battery-operatable electronic devices. This objective can be met with a cooling system as set out in claim 1.

The second objective of the invention is to bring out a portable battery-operatable electronic device that comprises an improved cooling system for a component that produces heat in use. This objective can be met with a device as set out in claim 12.

The dependent claims describe various advantageous embodiments of the invention.

### Advantages of the invention

If a cooling system for a portable battery-operatable electronic device having a housing comprises a heat conducting element comprising at least three directional branches pointing in different directions, the heat conducting element thermally coupled to a component, the component preferably assembled on a circuit board, and at least three of the directional branches each connected to at least one passage leading to at least one opening in the exterior of the electronic device, or to a part of the exterior that is a water-proof structure, especially foil or coating, that is permeable for air, at least two of said openings or parts being on opposite sides of said housing, a cooling system that can benefit of density gradient driven convection caused by thermal expansion of a gas can be obtained, in a manner much similar to a chimney where hot air rises.

The at least three directional branches may ensure that the density gradient driven convection works regardless on in which position the cooling system must operate, or at least to enable a proper cooling in horizontal and vertical positions, which are the most important ones since many portable battery-operatable electronic devices may be operated on a table or in hand.

If a part of the exterior that is permeable for air is not permeable for dust or water, dirt, dust and water can be better kept out of the electronics. This area can easily be cleaned (like the cover of the display, especially a glass or plastic cover and other outer parts of the portable battery-operatable electronic device).

Because the heat conducting element is thermally coupled to the component that generates heat and because its directional branches are connected to the passages, heat will be conducted away from the heat source, and since the temperature of the heat conducting element is higher than that of air entering the branch of heat-conducting element, heating the air, the density gradient may be increased thus improving heat convection.

If each of the at least three passages comprises an essentially straight portion, the direction of which is so selected that it or its extension spans a straight or an obtuse angle with another essentially straight portion, it can be ensured that if the portable battery-operatable electronic device is suddenly held in a different position, the airflow can change direction by changing to other branches heat conducting elements, and thereby also to another passage of the cooling system. As an effect, the achieved cooling may be continuous and omni- or even multi directional.

If the heat conducting element is of different material than the passages, the temperature distribution of the passages may have a larger gradient than in the heat conducting element, with an effect that improved heat convection may be achieved. This is especially the case if the heat conducting element is made of metal, and/or the passages are made of at least one polymer. In this manner, a particular low cost of manufacture can be obtained. In particular, the heat conducting element may be surface mounted on the circuit board whereas the passages may be integrated in the outer mechanics.

If at least one directional branch of the heat conducting element passes through the circuit board, a relatively simple manner to increase the height of the passage can be obtained when the portable battery-operatable electronic device is placed on a surface, assuming that the size of the portable battery-operatable electronic device is mostly dominated by the circuit board. If there is a certain height for the passage required, by passing at least one of them through the circuit board, the device can be made respectively smaller since there is no need to by-pass the circuit board from a side.

In the simplest form of the cooling system, the density gradient driven convection does not need current. If necessary, density gradient driven convection can be boosted by increasing the temperature gradient in the cooling system or by mechanically moving air in the cooling system. For this purpose, the cooling system may further comprise a cooling unit for increasing air flow in at least one of the passages. In particular, the cooling unit may be an air pump or a fan, or comprise a Peltier element in one of the branches or in the passages.

If the cooling unit comprises an air pump or a fan, the cooling system may further comprise a unit adapted to change pumping direction of the air pump or rotating direction of the fan in response to a change of orientation of the cooling system or of the portable battery-operatable electronic device. This may improve the operation of the cooling system in response to the device being in a different position, because the cooling system does not need to work against the natural convection.

### List of drawings

In the following, the invention is described in more detail with reference to examples shown in accompanying drawings in Figures 1 to 7C, of which:
Figure 1 shows a portable battery-operatable electronic device defining directions for Figures 2A to 7C;
Figures 2A, 3A, 4A, 5A, 6A, and 7A are sectional views portable battery-operatable electronic devices showing different possibilities for designing or assembling the heat conducting element and the passages connected to the directional branches of the heat conducting element; and
Figures 2B, 3B, 4B, 5B, 6B, and 7B are see-through-views as seen from the front side of the portable battery-operatable electronic devices shown in Figures 2A, 3A, 4A, 5A, 6A, and 7A, respectively.

Figures 2C, 3C, 4C, 5C, 6C, and 7C are see-through-views as seen from the top side of the portable battery-operatable electronic devices shown in Figures 2A, 3A, 4A, 5A, 6A, and 7A, respectively.

Same reference numerals and oval markings or circles refer to similar structural elements throughout the Figures.

### Detailed description

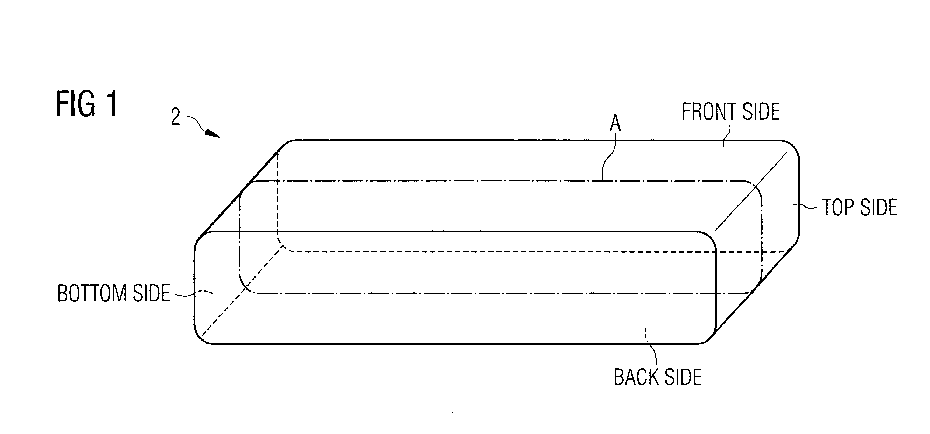

Figure 1 illustrates the housing of a portable telephone 2. The housing of the portable telephone 2 may but does not need to have an elongated shape. Especially but not only if the portable telephone 2 has a bar-shaped form, it preferably has a shape that lets a front side, a top side, a bottom side and a back shape to be recognized by looking.

The front side is preferably the side that comprises a display, preferably a keyboard, a loudspeaker opening and a microphone opening.

The portable telephone 2 can be a clam-shell or slider telephone. In this case, the movable part of the housing or the slider cover, respectively, has been omitted from Figure 1.

If the portable telephone 2 is used in "normal mode", i.e. in hand, slightly pressed against the ear, the top side most probably points towards the ear of the user and the bottom side to the mouth of the user. If the user is standing or sitting, the portable telephone 2 is in a vertical position, the top side pointing then more or less directly upwards.

If the user is lying, or if the portable telephone 2 is used in "hands-free mode", i.e. on table or another flat surface, the portable telephone 2 is in a horizontal position, the bottom side and the top side being more or less in the same level.

Similar kind of consideration may apply for a portable telephone that is capable of sending still or video images and that can be used in different positions. A further example includes a portable telephone that can be used as hand-held or body-worn telephone.

The portable telephone 2 comprises a power amplifier for amplifying a signal that is transmitted to another portable telephone or to a base station, such as a base station for cordless ISDN, PSTN (DECT), or VoIP telephones, or to a cellular base station for cellular telephones, such as GSM, UMTS, CDMA, WCDMA, CDMA2000, or UTRA/FDD mobile telephones. The signal to be transmitted is usually in the microwave region, and preferably somewhere in the range of 20 MHz to 10 GHz.

Because of the frequency and depending on the used transmitting power, efficiency and modulation method, the power amplifier tends to generate much heat depending on the transmitting power, efficiency of the modulation, duty cycle and transmit time. The traditional solution has been to add holes to the housing and other outer mechanics that are often made from plastic. By this way, hot air can escape the portable telephone and cooler air can enter into the portable telephone from its surrounding.

The holes in the housing, as in many current designs, provide a rather random cooling as supposed to a cooling directed to the hot spots in the portable telephone. The holes in the mechanics and in the housing also let in dirt, dust, filth, water and sweat directly into the electronics that can easily lead to malfunction or ruin the electrical performance.

Dust filters could relieve this problem at part, but their main problem is that they reduce or inhibit the heat convection by significantly reducing the flow of air from and to the housing. Furthermore, dust filters tend to have an insolating effect.

The excess heat in the portable telephone 2 may become a problem if it cannot be properly removed. Especially with modern modulations schemes, where the objective is to transfer high data rates using a limited bandwidth, the linearity requirements for the transmitters are very strict. And the more linear the transmitter must be, the less efficient it tends to be or more complicated linearization techniques it needs, increasing need for computation or components.

If the portable telephone 2 is relatively small, the antenna is extremely close to the person using the device, usually because the user's hands or head are in the near-field of the antenna. This tends to change the operating conditions of the transmitter, especially because of the changing of the standing wave ratio, which again would tend to lower the efficiency of the power amplifier, resulting in higher heat generation.

The surface temperature of the power amplifier can get very high. At 100 °C, the power amplifier cannot usually fulfill the specified requirements, and above 120 °C it can get permanently damaged. Since it is very difficult to say how a particular power amplifier will behave, the design work must be made more accurately in order for the wireless transmitter not to violate type approval and specified requirements, as laid down in plurality of standards, such as GSM, UMTS, CDMA, WCDMA, CDMA2000, or UTRA/FDD.

The excess heat in the portable telephone 2 may thus not only result in undesired radiation or unwanted radiation spectrum, too low output power or degraded receiver sensitivity, but also in various power supply problems due to power management unit overheating, stopped oscillators and in dropped calls due to computing errors made by the processing unit or digital signal processor.

Further parts of the portable telephone 2 that can also heat up are the processing unit, the digital signal processor and battery. This may happen in particular when the bit rate goes up.

The parts in a portable telephone 2 that generate much heat are sometimes referred to as hot spots.

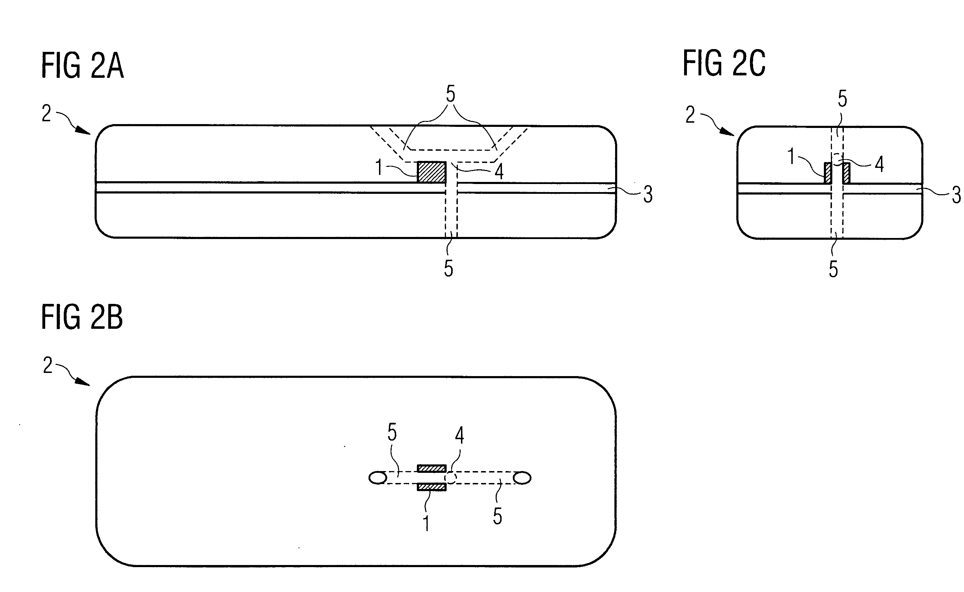

Figure 2A is a sectional view of a portable telephone 2. The portable telephone comprises a power amplifier 1 assembled on a circuit board 3.

Figure 2B is a see-through view of the portable telephone 2 of Figure 2A as seen from the front side. Because in practice the portable telephone 2 is preferably not transparent, in a front view of the portable telephone 2 there would be only holes (marked with the ovals) in the housing visible. If instead of holes, there are parts of the exterior that both are water-proof structure, especially foil or coating that is permeable for air, the ovals would denote such structures.

Figure 2C is a see-through view of the portable telephone 2 of Figure 2A as seen from the top side. Because in practice the portable telephone 2 is preferably not transparent, in a top view of the portable telephone 2 there would be only a hole (marked with the circle) in the housing visible. If instead of a hole, there is a part of the exterior that is a water-proof structure, especially foil or coating that is permeable for air, the oval would denote such structure.

According to one aspect of the invention, the portable telephone 2 comprises a heat conducting element 4 that has at least three directional branches pointing in different directions. The heat conducting element 4 is preferably thermally coupled to the power amplifier 1.

At least three of the directional branches are each connected to at least one passage 5 leading to at least one opening in the exterior of portable telephone 2. Instead or in addition of the openings, at least one of the passages 5 may lead to a part of the exterior that comprises a water-proof structure, especially foil or coating, that is permeable for air.

At least two of said openings or parts of the exterior that comprises a water-proof structure that is permeable for air are located on opposite sides of the housing of the portable telephone 2.

The heat conducting element 4 is preferably of material with high thermal conductivity, like most metals. The heat conducting element 4 can be thermally connected to the power amplifier 1, to a power amplifier shield, or to any other hot spot by mounting it in close proximity of the component causing the hot spot. In addition or instead of the power amplifier 1, the component causing the hot spot may be a processing unit (especially a microprocessor), a digital signal processor, or power management unit.

The heat conducting element 4 is preferably hollow in order to improve heat exchange between the component to which it has been thermally coupled and the air inside the heat conducting element 4 or in the directional branches.

A purpose for the directional branches is to direct the cooling air flow. They are connected to the surrounding of the portable telephone 2 via passages 5 that are kind of air ducts in the mechanics preferably made from a less heat conducting material, such as of plastic.

The cross-sections of the passages 5 do not need to be round or oval, but the cross-section of some or all of the passages 5 may be rectangular or square.

The number of the directional branches in the heat conducting element 4 is arbitrary. Furthermore, their directions can be chosen arbitrarily.

The inside surface of at least one of the directional branches may be serrated or have fins to increase the surface area and to improve heat exchange from the heat conducting element 4 to air passing through the heat conducting element 4.

The heat conducting element 4 can be mounted in many different ways in close proximity to the power amplifier 1 or to any component causing the hot spot. For example, it can be soldered or glued with heat conducting glue to the circuit board 3 as close to the power amplifier 1 (or the component causing the hot spot) as heat wise possible. The heat conducting element 4 and the power amplifier 1 (or the component causing the hot spot) have preferably same ground plane of a material with good heat conductivity. The thermal connecting between the heat conducting element and the power amplifier 1 or the component causing the hot spot may be made over an area via through holes or channels filled with material that has high heat conductivity.

The thermal connecting may be performed by soldering, welding or glueing with heat conducting glue the heat conducting element 4 not directly to the power amplifier 1 or to the other component causing the hot spot but to the shield of the power amplifier 1 or of the other component.

The heat conducting element 4 may be an integrated part of the shield of the power amplifier 1 or of the other component.

The heat conducting element 4 may be placed in close proximity of the power amplifier 1 or of the other component as an integrated part of the outer mechanics, then preferably mounted in the outer plastic shell.

In particular, the heat conducting element 4 can be realized as a cross shaped metal tube connecting to the ambient air in three, four or more directions.

In Figure 2A, the heat conducting element 4 that consists of a cross shaped metal tube is soldered as a through-hole PCB component on the circuit board. The heat conducting element 4 is connected to the ambient air via passages 5 that may consist of plastic tubes in the outer mechanics of the portable telephone 2.

Some or all of the passages 5 may be water- and dust proof so that water and dust entering in the passage 5 would not get in contact with the circuit board 3 or the electronics inside the housing. The resistance for dust and proof can be obtained by making the passage 5 from a water- and dust-proof material or coating it with such a material.

The temperature of the air inside the heat conducting element 4 increases when the temperature of the component to be cooled is higher than the temperature of the air inside the heat conducting element 4 since the heat conducting element 4 and the component are thermally connected. The warm air inside the heat conducting element 4 undergoes thermal expansion, its density decreases and the density gradient driven convection makes the air to rise and flow through the passage 5 and out of the portable telephone 2 through at least one opening in the housing or a part of the exterior that is a water-proof structure permeable for air, such as Gore-Tex ®.

Cooler air will enter the heat conducting element 4 from the passage 5 pointing downwards, resulting in a flow of cool air though the heat conducting element close to the hot spot. This results in a cooling effect of the hot spot.

The cooling system may comprise a cooling unit. The cooling unit may comprise at least one Peltier element, at least one air pump, or at least one fan.

If the cooling unit comprises one or more Peltier elements, it is or they are preferably positioned between the component causing the hot spot and the heat conducting element 4.

The cooling unit may comprise one or more air pumps or fans which is or are adapted to increase air flow in the direction of heat convection. In particular, because the direction of the heat convection may change in response to a change in the position of the portable telephone 2, the pumping direction of the air pump or the rotating direction of the fan may be changed responsive to a change in the position of the portable telephone.

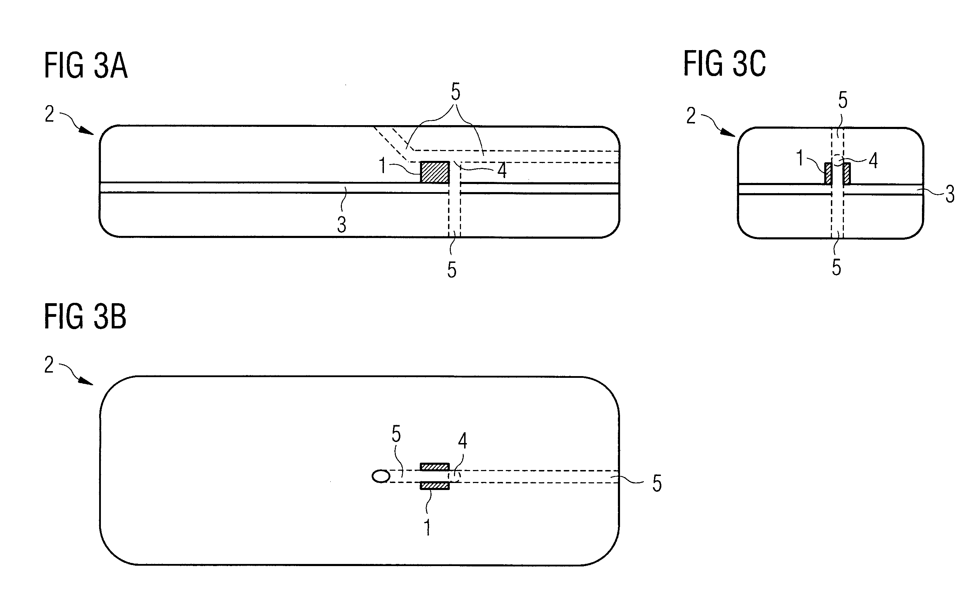

Figures 3A to 3C show another illustration of a portable telephone 2. One of the directional branches of the heat conducting element 4 points in a different direction, likewise one of the passages 5 extends now to a different sides than in the portable telephone of Figure 2A.

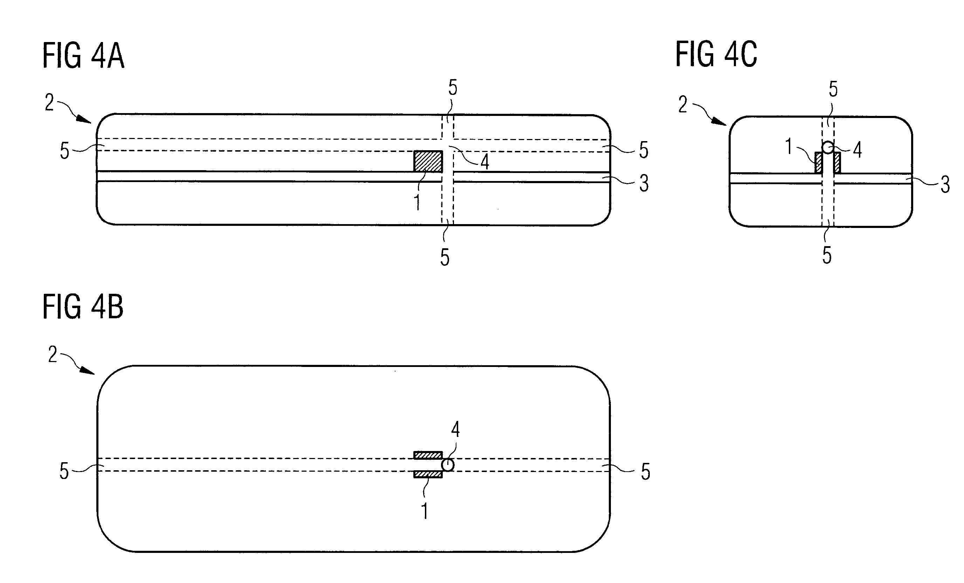

Figures 4A to 4C show another illustration of a portable telephone 2. The heat conducting element 4 now has four branches, the directions being to four sides of housing of the portable telephone 2.

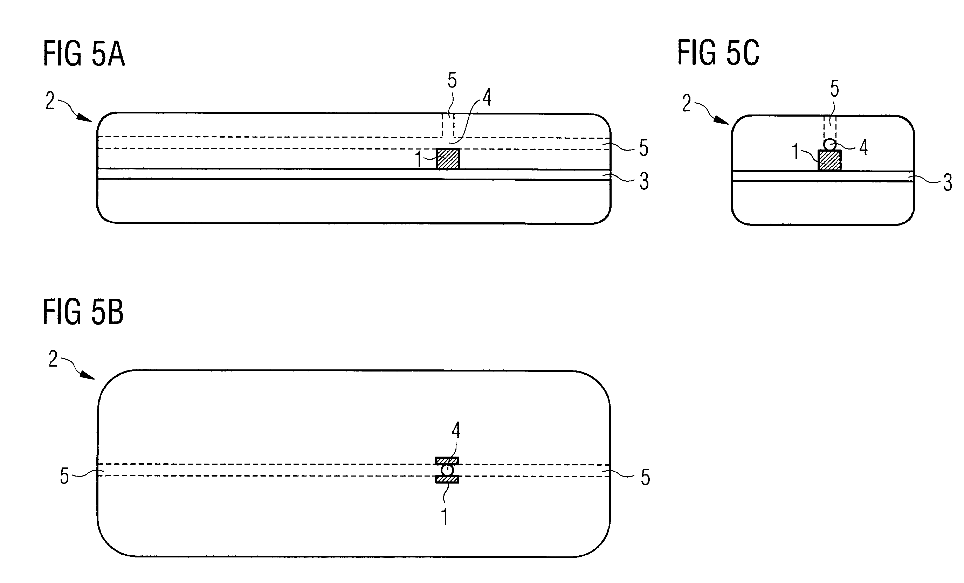

Figures 5A to 5C show a further illustration of a portable telephone 2. None of the directional branch of the heat conducting element 4 passes through the circuit board 3.

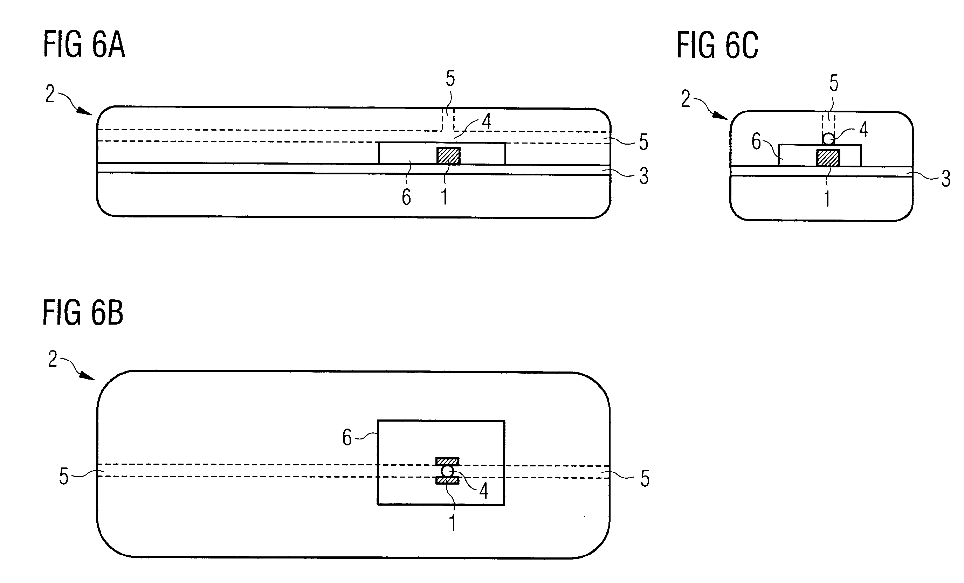

Figures 6A to 6C show a further illustration of a portable telephone 2 shown in Figure 5A. Now the heat conducting element 4 is mounted on shielding 6 of the power amplifier 1.

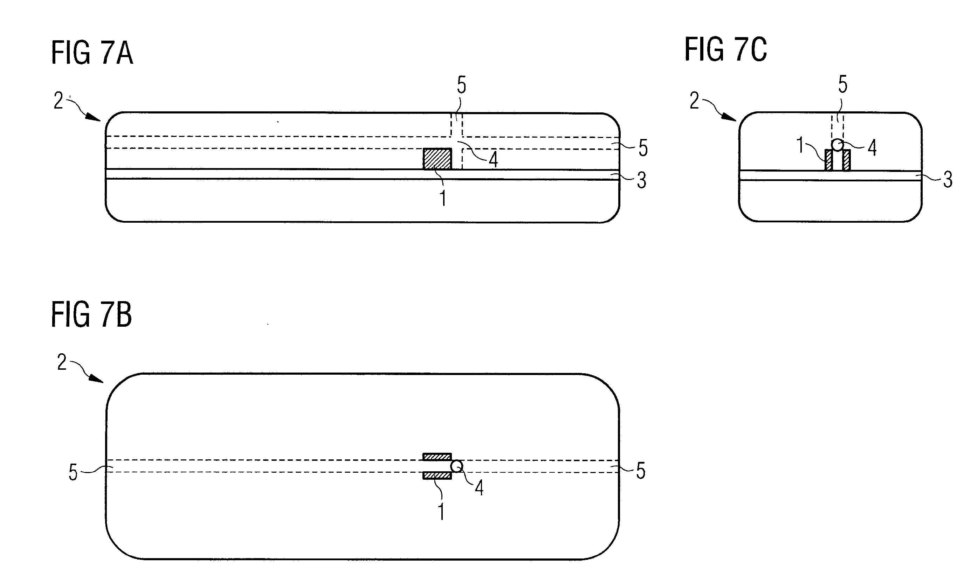

Figures 7A to 7C show a further illustration of a portable telephone 2. One directional branch of the heat conducting element 4 is now soldered to the circuit board 3.

Even though the invention has been described in more detail by using a portable telephone as an example, the skilled person appreciates that the invention is not limited to portable telephones but can be applied to all kinds of portable battery-operatable electronic devices that comprise such a component that might need cooling, the component preferably assembled on a circuit board. In particular, the portable battery-operatable electronic device may be a device comprising at least one wireless microwave transmitter, such as a palm top device, or a notebook.

## Claims

1. A cooling system for a portable battery-operatable electronic device (2) having a housing and at least one circuit board (3), the cooling system **comprising:** a heat conducting element (4) comprising at least three directional branches pointing in different directions, the heat conducting element (4) thermally coupled to a component (1), the component (1) preferably assembled on said circuit board (3), at least three of the directional branches each connected to at least one passage (5) leading to at least one opening in the exterior of the electronic device (2), or to a part of the exterior that is a water-proof structure, especially foil or coating, that is permeable for air, at least two of said openings or parts being on opposite sides of said housing.

2. A cooling system according to claim 1, **wherein:** each of the at least three passages comprises an essentially straight portion, the direction of which is so selected that it or its extension spans a straight or an obtuse angle with another essentially straight portion.

3. A cooling system according to claim 1 or 2, **wherein:** the heat conducting element (4) is of different material than the passages (5).

4. A cooling system according to any one of the preceding claims, **wherein:** the heat conducting element (4) is made of metal, and/or the passages (5) are made of at least one polymer.

5. A cooling system according to any one of the preceding claims, **wherein:** the heat conducting element (4) has been soldered onto the circuit board (3), or soldered or glued into the proximity of the component (1).

6. A cooling system according to any one of the preceding claims, **wherein:** at least one branch of the heat conducting element (4) passes through the circuit board (3).

7. A cooling system according to any one of the preceding claims, **wherein:** at least one of the passages (5) is water- and dust proof.

8. A cooling system according to any one of the preceding claims, **further comprising:** a cooling unit for increasing air flow in at least one of the passages (5).

9. A cooling system according to claim 8, **wherein:** the cooling unit comprises an air pump or a fan.

10. A cooling system according to claim 9, **further comprising:** means adapted to change the pumping direction of the air pump or rotating direction of the fan in changed response to a change of orientation of the cooling system or of the electronic device (2).

11. A cooling system according to claim 8, 9, or 10, **wherein:** the cooling unit comprises at least one Peltier element in the heat conducting element (4).

12. A portable battery-operatable electronic device (2) comprising a component (1) mounted on a circuit board (3), **characterized in that:** said portable battery-operatable electronic device (2) comprises a cooling system according to any one of the preceding claims.

13. A portable battery-operatable electronic device (2) according to claim 12, **wherein:** the component (1) is a power amplifier, a processing unit or DSP or a battery.

14. A portable battery-operatable electronic device (2) according to claim 12 or 13, **wherein:** said electronic device (2) comprises a wireless microwave transmitter.

15. A portable battery-operatable electronic device (2) according to claim 14, **wherein:** said heat conducting element (4) has been mounted on an RF shield (6).
